# EUROPEAN PATENT APPLICATION

(11) **EP 4 818 851 A1**
(43) Date of publication of application: **07.10.2026**
(21) Application number: 26152099.3
(22) Date of filing: 15.01.2026
(51) Int. Cl.: G06F 1/26, G06F 1/28, G06F 1/3206, G06F 1/3234

(54) **ON-DIE POWER SENSOR FOR PERFORMING RUN-TIME POWER/VOLTAGE/CURRENT MANAGEMENT**

(30) Priority: 01.04.2025 US 202563781987 P; 24.12.2025 US 202519432136
(71) Applicant: MediaTek Inc., Hsinchu City 30078 (TW)
(72) Inventor: LU, Chien-Yu, 30078 Hsinchu City (TW); HUANG, Bo-Jr, 30078 Hsinchu City (TW); TSAI, Chih-Fu, 30078 Hsinchu City (TW); FANG, Jia-Wei, 30078 Hsinchu City (TW)
(74) Representative: Hoefer & Partner Patentanwälte mbB

(57) **Abstract**

An on-die power sensor (100) includes a digital current sensor (10), a digital voltage sensor (20) and a power calculator (40) for performing run-time power/voltage/current management. The digital current sensor (10) measures speed counts of two identical ring oscillators (ROSC1, ROSC2), acquire an overall delta speed count between the two ring oscillators (ROSC1, ROSC2), converts the overall delta speed count to a voltage drop based on a trimmed slope of a first lookup table, and convert the voltage drop to a run-time current based on a trimmed DCR of a second lookup table. The digital voltage sensor (20) records values of the speed counts measured by the digital current sensor (10) to quantify a run-time voltage based on a third lookup table. The power calculator (40) obtains a run-time power by multiplying the run-time current and the run-time voltage.

## Description

### Field of the Invention

The present disclosure relates to an on-die power sensor and a related management method, and more particularly, to an on-die power sensor for performing run-time power/voltage/current management and a related method.

### Background of the Invention

A multi-core processor is a type of computer central processing unit (CPU) that contains two or more independent processing units, or cores, within a single chip. These processors are capable of executing multiple tasks simultaneously, such as with parallel processing and multithreading, leading to improved performance and efficiency compared to single-core processor. Multi-core processors are widely used in a variety of devices, from smartphones and laptops to servers and supercomputers.

In order to achieve power and performance-efficient capabilities for various computing demands like gaming or browsing, the CPU scheduling mechanism is introduced for optimizing the allocation of tasks to each core of the CPU based on predicted available power budgets. Further balancing of power and thermal distribution across the multiple cores is done to ensure sustainable performance. To ensure system stability, power calculation techniques at runtime consider factors of voltage, frequency and leakage, including pessimistic elements such as voltage guard band.

For tasks which require high frame rate per second (fps), display quality and durability, the intervals of power budgeting become shorter. Meanwhile, the CPU clock speeds increase to enhance performance for gaming, resulting in ever-higher current. Peak current grows faster than average current when high CPU performance is needed. The growing peak current causes over-current excursions to exceed the circuit tolerance, resulting in system instability that degrades CPU performance.

Therefore, there is a need for an on-die power sensor capable of performing run-time power/voltage/current management.

### Summary of the Invention

The present disclosure aims at providing an on-die power sensor for performing run-time power/voltage/current management and a related method.

This is achieved by an on-die power sensor for performing run-time power/voltage/current management according to claim 1 and a method of performing run-time power/voltage/current management according to claim 9. The dependent claims pertain to corresponding further developments and improvements.

As will be seen more clearly from the detailed description following below, the claimed on-die power sensor for performing run-time power/voltage/current management includes a digital current sensor, a digital voltage sensor and a power calculator. The digital current sensor includes a first ring oscillator selectively coupled to a first power voltage or a second power voltage in a processor; a second ring oscillator selectively coupled to the first power voltage or the second power voltage in the processor, wherein the first ring oscillator and the second ring oscillator are identical in structure; a counting unit configured to measure speed counts of the first ring oscillator and the second ring oscillator and acquire an overall delta speed count between the first ring oscillator and the second ring oscillator; and a conversion unit configured to convert the overall delta speed count between the first ring oscillator and the second ring oscillator to a voltage drop based on a trimmed slope of a first lookup table associated with a relationship between a speed count and an applied voltage of each ring oscillator; and convert the voltage drop to a run-time current based on a trimmed DCR of a second lookup table associated with a relationship between a DCR and the applied voltage of each ring oscillator. The digital voltage sensor is configured to record values of the speed counts measured by the digital current sensor to quantify a run-time voltage based on a third lookup table associated with a relationship between the speed count and the step voltage of each ring oscillator. The power calculator is configured to obtain a run-time power by multiplying the run-time current and the run-time voltage.

As will be seen more clearly from the detailed description following below, the claimed method of performing on-die run-time power/voltage/current management includes selectively coupling a first ring oscillator in a digital current sensor to a first power voltage or a second power voltage in a processor; selectively coupling a second ring oscillator in the digital current sensor to the first power voltage or the second power voltage in the processor, wherein the first ring oscillator and the second ring oscillator are identical in structure; measuring speed counts of the first ring oscillator and the second ring oscillator and acquiring an overall delta speed count between the first ring oscillator and the second ring oscillator using the digital current sensor; converting the overall delta speed count between the first ring oscillator and the second ring oscillator to a voltage drop based on a trimmed slope of a first lookup table associated with a relationship between a speed count and an applied voltage of each ring oscillator using the digital current sensor; converting the voltage drop to a run-time current based on a trimmed DCR of a second lookup table associated with a relationship between a DCR and the applied voltage of each ring oscillator using the digital current sensor; recording values of the speed counts measured by the digital current sensor to quantify a run-time voltage based on a third lookup table associated with a relationship between the speed count and a step voltage of each ring oscillator using a digital voltage sensor; and obtaining a run-time power by multiplying the run-time current and the run-time voltage.

### Brief Description of the Drawings

FIG. 1 is a functional diagram illustrating an on-die power sensor for performing run-time power/voltage/current management in a heterogeneous CPU according to an embodiment of the present disclosure.
FIG. 2 is a diagram illustrating an implementation of the inverters in a high-speed ring oscillator according to an embodiment of the present disclosure.
FIG. 3 is a diagram illustrating a method of acquiring the corresponding trimmed slope of a lookup table according to an embodiment of the present disclosure.
FIG. 4A is a diagram illustrating a method of calibrating a lookup table for compensating temperature effects according to an embodiment of the present disclosure.
FIG. 4B is a diagram illustrating a method of calibrating a lookup table for compensating temperature effects according to an embodiment of the present disclosure.
FIG. 5 is a diagram illustrating the operation of a digital voltage sensor in an on-die power sensor according to an embodiment of the present disclosure.

### Detailed Description

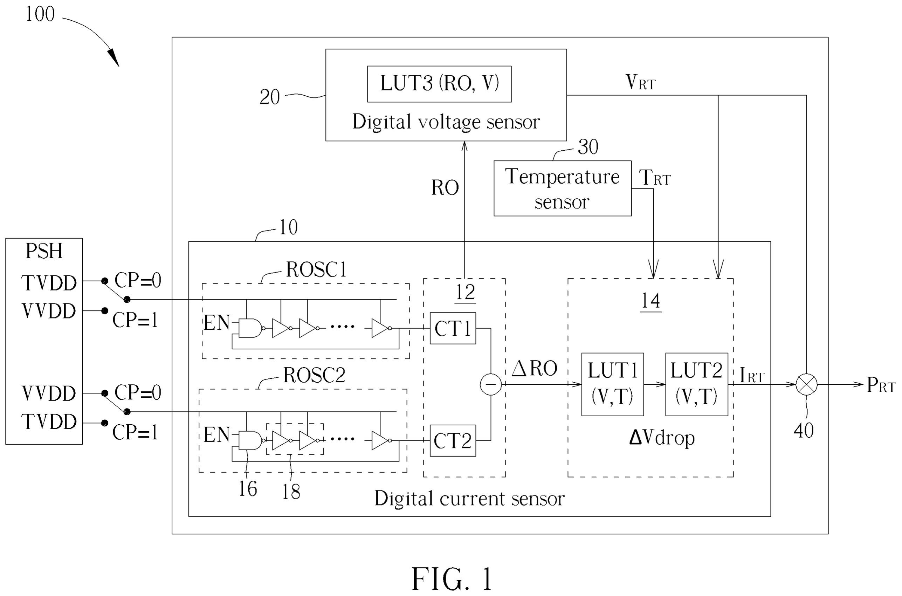

FIG. 1 is a functional diagram illustrating an on-die power sensor (ODPS) 100 for performing run-time power/voltage/current management in a heterogeneous CPU according to an embodiment of the present disclosure. The ODPS 100 includes a digital current sensor 10, a digital voltage sensor 20, a temperature sensor 30, and a power calculator 40.

Leverage power switches are used for connection, disconnection and protection against overload and short circuit of electrical power and low voltage electrical consumers. For example, in a heterogeneous CPU, a leverage power switch PSH may be used to isolate the true positive power voltage (TVDD) and the virtual positive power voltage (VVDD). In an embodiment, multiple on-die power sensors 100 of the present disclosure may be implemented on a heterogeneous multi-core CPU for monitoring the run-time power of each CPU. More specifically, the digital current sensor 10 of each ODPS 100 is configured to measure the run-time current I_{RT} of its corresponding CPU. The digital voltage sensor 20 of each ODPS 100 is configured to measure the run-time voltage V_{RT} of its corresponding CPU. The temperature sensor 30 of each ODPS 100 is configured to monitor the run-time temperature T_{RT} of its corresponding CPU during operation on a real-time basis. Based on the readings of the digital current sensor 10, the digital voltage sensor 20, and the temperature sensor 30 of each ODPS 100, the run-time power P_{RT} of each corresponding CPU may be obtained using the power calculator 40.

In the ODPS 100 of the present disclosure, the digital current sensor 10 includes two identical high-speed ring oscillators (HS-ROSCs) ROSC1 and ROSC2, a counting unit 12 and a conversion unit 14. Each of the high-speed ring oscillators ROSC1 and ROSC2 is selectively connected to the true positive power voltage TVDD (which is coupled to a first end of the leverage power switch PSH) and the virtual positive power voltage VVDD(which is coupled to a second end of the leverage power switch PSH). Each of the high-speed ring oscillators ROSC1 and ROSC2 is characterized in having its output frequency linearly related to its supply voltage (i.e., TVDD or VVDD). Given a detect window of voltage sensing, the frequency of each high-speed ring oscillator is recorded by the counting unit 12 in terms of digital speed count.

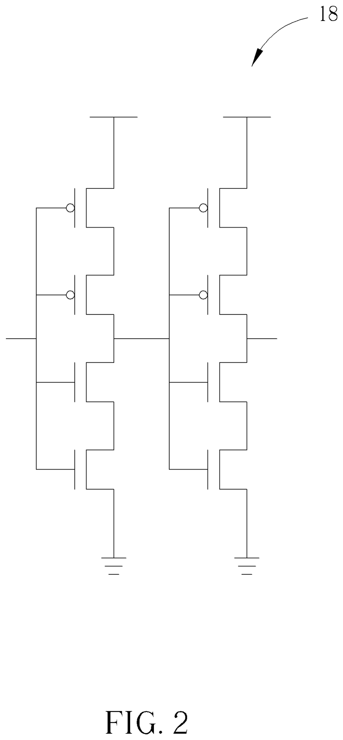

Each of the high-speed ring oscillators ROSC1 and ROSC2 includes a cascaded chain of inverting stages arranged in a ring, such that the output of the inverting stage at the end of the chain is fed back into the first inverting stage, which produces an output at the output of each inverting stage that oscillates between two voltage levels representing true and false. In the embodiment depicted in FIG.1, each of the high-speed ring oscillators ROSC1 and ROSC2 may be implemented by a 1^{st} stage NAND gate 16 followed by a plurality of inverters 18. FIG. 2 is a diagram illustrating an implementation of the inverters 18 in a high-speed ring oscillator according to an embodiment of the present disclosure. Each inverter 18 in the high-speed ring oscillators ROSC1 and ROSC2 may adopt an NMOS/PMOS-stacked configuration for further enhancing the voltage-sensing resolution. However, the method of implementing the high-speed ring oscillators ROSC1 and ROSC2 does not limit the scope of the present disclosure.

In the ODPS 100 of the present disclosure, the digital current sensor 10 is configured to measure the run-time current I_{RT} in 3 operational stages. In the first operational stage of the digital current sensor 10, the counting unit 12 is configured to measure the speed counts of the high-speed ring oscillators ROSC1 and ROSC2 during each detect window (such as 10µs detect window) and then calculate the difference between the speed counts of the high-speed ring oscillators ROSC1 and ROSC2. During two sequential detect windows with settings of CP=0 and CP=1, the high-speed ring oscillator ROSC1 and ROSC2 switch their supply rails between TVDD and VVDD. More specifically, during the detect window CP=0, the high-speed ring oscillator ROSC1 is coupled to TVDD and a corresponding voltage drop is measured as a speed count RO_{A0}, while the high-speed ring oscillator ROSC2 is coupled to VVDD and a corresponding voltage drop is measured as a speed count RO_{B0}. Similarly, during the subsequent detect window CP=1, the high-speed ring oscillator ROSC1 is coupled to VVDD and a corresponding voltage drop is measured as a speed count RO_{A1}, while the high-speed ring oscillator ROSC2 is coupled to TVDD and a corresponding voltage drop is measured as a speed count RO_{B1}.

After two sequential detect windows with settings of CP=0 and CP=1, the counting unit 12 is configured to acquire a delta speed count ΔRO_0 between the high-speed ring oscillators ROSC1 and ROSC2 during the detect window CP=0 and a delta speed count ARO_1 between the high-speed ring oscillators ROSC1 and ROSC2 during the detect window CP=1 by respectively subtracting the speed counts of the high-speed ring oscillator ROSC1 and ROSC2 during the detect windows CP=0 and CP=1 (i.e., ΔRO_0=RO_{A0}-RO_{B0} and ΔRO_1=RO_{A1}-RO_{B1}), thereby canceling the intrinsic speed offset between the high-speed ring oscillator ROSC1 and ROSC2. Then, the counting unit 12 is configured to acquire the overall delta speed count ΔRO by averaging the delta speed counts of the two detect windows CPO and CP1 (i.e., ΔRO=(ΔRO_0+ARO_1)/2).

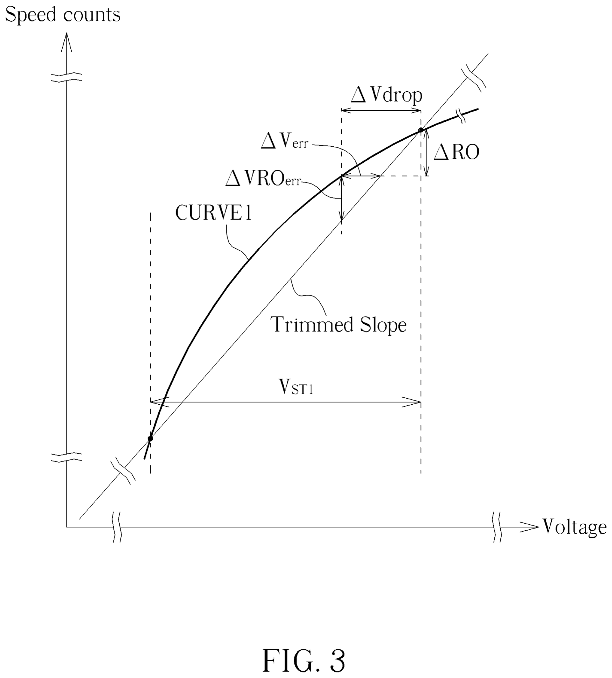

In the second operational stage of the digital current sensor 10, the conversion unit 14 is configured to convert the delta speed count ΔRO between the high-speed ring oscillators ROSC1 and ROSC2 to a voltage drop ΔVdrop based on the trimmed slope of a lookup table LUT1(V,T) associated with the relationship between the speed count and applied the voltage of each high-speed ring oscillator. FIG. 3 is a diagram illustrating a method of acquiring the corresponding trimmed slope of the lookup table LUT1(V,T) according to an embodiment of the present disclosure. Since the frequency of oscillation in a ring oscillator is directly related to the delay of each inverting stage, which in turn is influenced by the voltage applied to the ring oscillator, the relationship between the speed count and the applied voltage of each high-speed ring oscillator may be acquired, as depicted by CURVE1 in FIG. 3. A proper trimming voltage step V_{ST1} associated with the run-time voltage V_{RT} may then be applied to the above-mentioned speed count-applied voltage relationship (CURVE1) for acquiring the corresponding trimmed slope so as to ensure that the voltage drop error rate (ΔVerr/ΔVdrop) is less than 3%, covering all sign-off corner specifications. In an embodiment, an additional fine-grained interpolation hardware mechanism which covers the process variation may also be adopted to make the calibrated trimmed slope closer to the real curve of the original speed count-applied voltage relationship (CURVE1), thereby achieving low voltage drop error rate for voltage conversion with limited trimming steps due to cost concerns. Next, the overall delta speed count ΔRO may be converted to ΔVdrop (TVDD-VVDD) based on the trimmed slope of the lookup table LUT1(V,T) with limited nonlinearity error in FIG. 3 (i.e., ΔVdrop=ΔRO/trimmed slope).

In the third operational stage of the digital current sensor 10, the conversion unit 14 is configured to convert the voltage drop ΔVdrop to the run-time current I_{RT} based on a lookup table LUT2(V,T) associated with the relationship between the direct current resistance (DCR) and the applied voltage of each high-speed ring oscillator. Since the DCR of a ring oscillator varies with its applied voltage, the relationship between the DCR and the trimmed slope voltage of each high-speed ring oscillator may be acquired as a curve in the lookup table LUT2(V,T). The same trimming voltage step depicted in FIG. 3 may then be applied to the above-mentioned DCR-trimmed slope voltage curve so as to acquire the trimmed DCR of the lookup table LUT2(V,T). Next, the run-time current I_{RT} may be obtained based on the voltage drop ΔVdrop and the trimmed DCR of the lookup table LUT2(V,T) (i.e., I_{RT} =ΔVdrop/trimmed DCR).

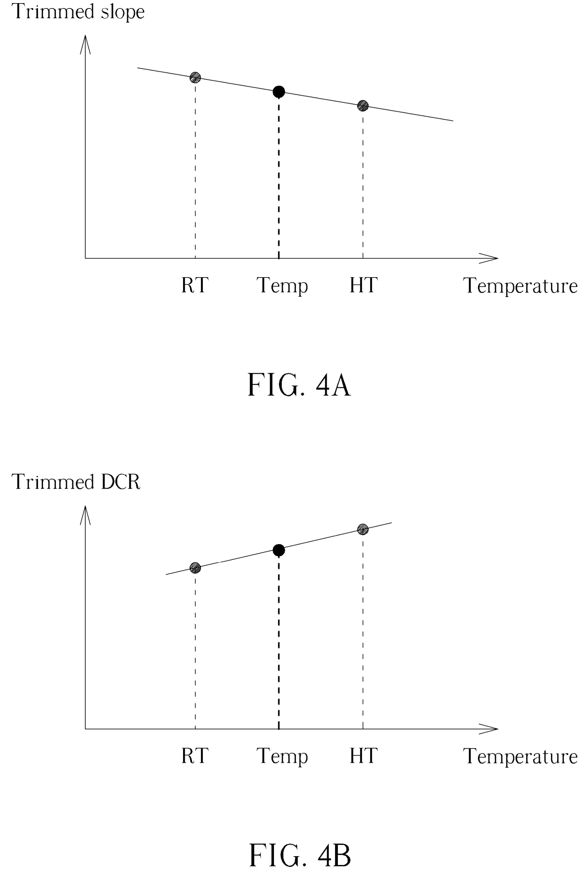

In an embodiment, temperature effects on the digital current sensor 10 may further be addressed by calibrating the trimmed slope of the lookup table LUT1(V,T)and the trimmed DCR of the lookup table LUT2(V,T). FIGs. 4A and 4B are diagrams illustrating methods of calibrating the trimmed slope of the lookup table LUT1(V,T) and the trimmed DCR of the lookup table LUT2(V,T) for compensating temperature effects according to an embodiment of the present disclosure. As depicted in FIG. 4A, the relationship between the trimmed slope of the lookup tables LUT1(V,T) and temperature may be measured or simulated at a certain temperature range RT-HT (such as 25°C to 85°C). After acquiring the trimmed slope of the lookup tables LUT1(V,T) in the second operational stage of the digital current sensor 10, hardware interpolation may be utilized based on the instant temperature Temp acquired by the temperature sensor 30 and FIG. 4A to further suppress the error rate. As depicted in FIG. 4B, the relationship between the trimmed DCR of the lookup tables LUT2(V,T) and temperature may be measured or simulated at a certain temperature range RT-HT (such as 25°C to 85°C). After acquiring the trimmed DCR of the lookup table LUT2(V,T) in the second operational stage of the digital current sensor 10, hardware interpolation may be utilized based on the instant temperature Temp acquired by the temperature sensor 30 and FIG. 4B to further suppress the error rate.

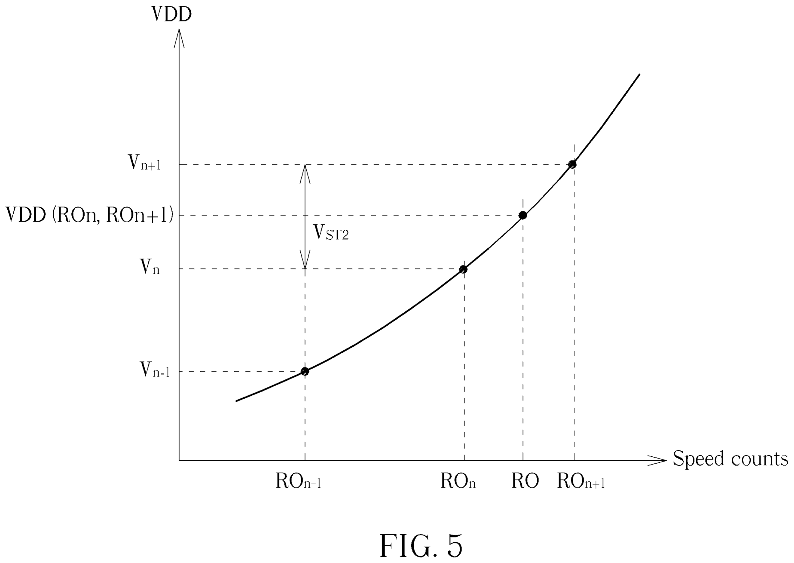

FIG. 5 is a diagram illustrating the operation of the digital voltage sensor 20 in the on-die power sensor 100 according to an embodiment of the present disclosure. In the ODPS 100 of the present disclosure, the digital voltage sensor 20 is configured to synchronously record the speed counts of each high-speed ring oscillator to quantify the run-time voltage V_{RT} after each detect window based on a lookup table LUT3(RO,V) associated with the relationship between the speed count and the step voltage of each high-speed ring oscillator. After receiving a speed count value RO measured by the digital current sensor 10, the digital voltage sensor 20 may acquire the closest speed count values ROₙ and ROₙ₊₁ and their corresponding step voltages Vₙ and Vₙ₊₁ based on the lookup table LUT3(RO,V), wherein the trim step voltage V_{ST2} is defined by (Vₙ₊₁-Vₙ). Next, the run-time voltage V_{RT} may then be interpolated between Vₙ and Vₙ₊1 based on the speed count values ROₙ and ROₙ₊₁, wherein V_{RT}=Vₙ+ V_{ST}*(RO-ROₙ)/(ROₙ₊₁-ROₙ). The run-time voltage V_{RT} is used for calibrating the trimmed slope of the lookup table LUT1(V,T) and the trimmed DCR of the lookup table LUT2(V,T) of the digital current sensor 10 and for calculating the run-time power P_{RT}.

Last, the run-time power P_{RT} of each corresponding CPU may be obtained using the power calculator 40 based on the readings of the digital current sensor 10, the digital voltage sensor 20, and the temperature sensor 30 (i.e., P_{RT}= V_{RT}*I_{RT}).

In conclusion, the ODPS 100 of the present disclosure is able to perform run-time power/current management for the purpose of achieving high-quality performance, computing efficiency and sustained power delivery in a heterogeneous CPU. Since the present ODPS 100 is capable of monitoring CPU on-time current in 10µs detect windows, it may be applied to over-current control (OCC) for limiting the over-current excursion and ensuring power stability without observable performance loss. When running a game, the present ODPS 100 may profile per-core CPU power consumption, providing dynamic run-time conditions to optimize power for a better user experience and battery life.

## Claims

1. An on-die power sensor (100) for performing run-time power/voltage/current management, comprising:
a power calculator (40) configured to obtain a run-time power by multiplying a run-time current and a run-time voltage; and
a digital current sensor (10) comprising:
a first ring oscillator (ROSC1) selectively coupled to a first power voltage (TVDD) or a second power voltage (VVDD) in a processor;
a second ring oscillator (ROSC2) selectively coupled to the first power voltage (TVDD) or the second power voltage (VVDD) in the processor, wherein the first ring oscillator (ROSC1) and the second ring oscillator (ROSC2) are identical in structure;
a counting unit (12) configured to measure speed counts of the first ring oscillator (ROSC1) and the second ring oscillator (ROSC2) and acquire an overall delta speed count between the first ring oscillator (ROSC1) and the second ring oscillator (ROSC2);
a conversion unit (14); and
a digital voltage sensor (20);
**characterized in that:**
the conversion unit (14) is configured to:
convert the overall delta speed count between the first ring oscillator (ROSC1) and the second ring oscillator (ROSC2) to a voltage drop based on a trimmed slope of a first lookup table associated with a relationship between a speed count and an applied voltage of each ring oscillator (ROSC1, ROSC2); and
convert the voltage drop to the run-time current based on a trimmed direct current resistance, DCR, of a second lookup table associated with a relationship between a DCR and the applied voltage of each ring oscillator (ROSC1, ROSC2); and
the digital voltage sensor (20) is configured to record values of the speed counts measured by the digital current sensor (10) to quantify the run-time voltage based on a third lookup table associated with a relationship between the speed count and a step voltage of each ring oscillator (ROSC1, ROSC2).

2. The on-die power sensor (100) of claim 1, **characterized in that:**
the first ring oscillator (ROSC1) is coupled to the first power voltage (TVDD) during a first detect window and coupled to the second power voltage (VVDD) during a second detect window subsequent to the first detect window;
the second ring oscillator (ROSC2) is coupled to the second power voltage (VVDD) during the first detect window and coupled to the first power voltage (TVDD) during the second detect window; and
the counting unit is further configured to:
measure a first speed count of the first ring oscillator (ROSC1) during the first detect window and a first speed count of the second ring oscillator (ROSC2) during the first detect window;
measure a second speed count of the first ring oscillator (ROSC1) during the second detect window and a second speed count of the second ring oscillator (ROSC2) during the second detect window;
acquire a first delta speed count between the first ring oscillator (ROSC1) and the second ring oscillator (ROSC2) during the first detect window by subtracting the first speed count of the second ring oscillator (ROSC2) from the first speed count of the first ring oscillator (ROSC1);
acquire a second delta speed count between the first ring oscillator (ROSC1) and the second ring oscillator (ROSC2) during the second detect window by subtracting the second speed count of the second ring oscillator (ROSC2) from the second speed count of the first ring oscillator (ROSC1); and
acquire the overall delta speed count by averaging the first delta speed count and the second delta speed count.

3. The on-die power sensor (100) of claim 2, further **characterized by** comprising a temperature sensor (30) configured to measure an instant temperature of the on-die power sensor (100), wherein the conversion unit (14) is further configured to calibrate the first lookup table and the second lookup table based on the instant temperature.

4. The on-die power sensor (100) of any of claims 1-3, **characterized in that:**
the first ring oscillator (ROSC1) includes a first cascaded chain of inverting stages arranged in a first ring; and
the second ring oscillator (ROSC2) includes a second cascaded chain of inverting stages arranged in a second ring.

5. The on-die power sensor (100) of any of claims 1-4, **characterized in that** the digital voltage sensor (20) is further configured to:
receive a measured speed count value from the digital current sensor (10);
acquire a first speed count value and a second speed count value which are closest to the measured speed count value based on the third lookup table;
acquire a first step voltage corresponding to the first speed count value and a second step voltage corresponding to the second speed count value based on the third lookup table; and
quantify the run-time voltage by interpolating between the first step voltage and the second step voltage based on the first speed count value and the second speed count value.

6. The on-die power sensor (100) of claim 5, **characterized in that** the conversion unit (14) is further configured to:
calibrate the first lookup table based on the run-time voltage for obtaining the trimmed slope of the first lookup table; and
calibrate the second lookup table based on the run-time voltage for obtaining the trimmed DCR of the second lookup table.

7. A method of performing on-die run-time power/voltage/current management, comprising:
selectively coupling a first ring oscillator (ROSC1) in a digital current sensor (10) to a first power voltage (TVDD) or a second power voltage (VVDD) in a processor;
selectively coupling a second ring oscillator (ROSC2) in the digital current sensor (10) to the first power voltage (TVDD) or the second power voltage (VVDD) in the processor, wherein the first ring oscillator (ROSC1) and the second ring oscillator (ROSC2) are identical in structure; and
measuring speed counts of the first ring oscillator (ROSC1) and the second ring oscillator (ROSC2) and acquiring an overall delta speed count between the first ring oscillator (ROSC1) and the second ring oscillator (ROSC2) using the digital current sensor (10);
**characterized by** further comprising:
converting the overall delta speed count between the first ring oscillator (ROSC1) and the second ring oscillator (ROSC2) to a voltage drop based on a trimmed slope of a first lookup table associated with a relationship between a speed count and an applied voltage of each ring oscillator (ROSC1, ROSC2) using the digital current sensor (10);
converting the voltage drop to a run-time current based on a trimmed direct current resistance, DCR, of a second lookup table associated with a relationship between a DCR and the applied voltage of each ring oscillator (ROSC1, ROSC2) using the digital current sensor (10);
recording values of the speed counts measured by the digital current sensor (10) to quantify a run-time voltage based on a third lookup table associated with a relationship between the speed count and a step voltage of each ring oscillator (ROSC1, ROSC2) using a digital voltage sensor (20); and
obtaining a run-time power by multiplying the run-time current and the run-time voltage.

8. The method of claim 7, **characterized by** further comprising:
coupling the first ring oscillator (ROSC1) to the first power voltage (TVDD) during a first detect window and coupling to the second power voltage (VVDD) during a second detect window subsequent to the first detect window;
coupling the second ring oscillator (ROSC2) to the second power voltage (VVDD) during the first detect window and coupling to the first power voltage (TVDD) during the second detect window;
measuring a first speed count of the first ring oscillator (ROSC1) during the first detect window and a first speed count of the second ring oscillator (ROSC2) during the first detect window using the digital current sensor (10);
measuring a second speed count of the first ring oscillator (ROSC1) during the second detect window and a second speed count of the second ring oscillator (ROSC2) during the second detect window using the digital current sensor (10);
acquiring a first delta speed count between the first ring oscillator (ROSC1) and the second ring oscillator (ROSC1) during the first detect window by subtracting the first speed count of the second ring oscillator (ROSC2) from the first speed count of the first ring oscillator (ROSC1) using the digital current sensor (10);
acquiring a second delta speed count between the first ring oscillator (ROSC1) and the second ring oscillator (ROSC2) during the second detect window by subtracting the second speed count of the second ring oscillator (ROSC2) from the second speed count of the first ring oscillator (ROSC1) using the digital current sensor (10); and
acquire the overall delta speed count by averaging the first delta speed count and the second delta speed count using the digital current sensor (10).

9. The method of claim 8, **characterized by** further comprising:
measuring an instant temperature using a temperature sensor (30); and
calibrating the first lookup table and the second lookup table based on the instant temperature using the digital current sensor (20).

10. The method of any of claims 7-9, **characterized by** further comprising:
providing the first ring oscillator (ROSC1) by arranging a first cascaded chain of inverting stages in a first ring; and
providing the second ring oscillator (ROSC2) by arranging a second cascaded chain of inverting stages in a second ring.

11. The method of any of claims 7-10, **characterized by** further comprising:
receiving a measured speed count value from the digital current sensor (10) using the digital voltage sensor (20);
acquiring a first speed count value and a second speed count value which are closest to the measured speed count value based on the third lookup table using the digital voltage sensor (20);
acquiring a first step voltage corresponding to the first speed count value and a second step voltage corresponding to the second speed count value based on the third lookup table using the digital voltage sensor (20); and
quantifying the run-time voltage by interpolating between the first step voltage and the second step voltage based on the first speed count value and the second speed count value using the digital voltage sensor (20).

12. The method of claim 11, **characterized by** further comprising:
calibrating the first lookup table based on the run-time voltage using the digital current sensor (10) for obtaining the trimmed slope of the first lookup table; and
calibrating the second lookup table based on the run-time voltage using the digital current sensor (10) for obtaining the trimmed DCR of the second lookup table.

13. The on-die power sensor (100) of claim 4 and the method of claim 10, **characterized in that:**
at least of one inverting stage in the first cascaded chain of inverting stages adopts a MOS-stacked configuration; and
at least of one inverting stage in the second cascaded chain of inverting stages adopts the MOS-stacked configuration.

14. The on-die power sensor (100) of any of claims 1-6 and the method of any of claims 7-13, **characterized in that**:
the first power voltage (TVDD) is a true positive power voltage coupled to a first end of a power switch (PSH) in the processor; and
the second power voltage (VVDD) is a virtual positive power voltage coupled to a second end of the power switch (PSH) in the processor.
